# EUROPEAN PATENT APPLICATION

(11) **EP 0 555 971 A1**
(43) Date of publication of application: **18.08.1993**
(21) Application number: 93300601.7
(22) Date of filing: 27.01.1993
(51) Int. Cl.: H01B 12/00

(54) **Process for making superconductors with high critical current densities**

(30) Priority: 12.02.1992 US 835163
(71) Applicant: International Business Machines Corporation, Armonk, N.Y. 10504 (US)
(72) Inventor: Beyers, Robert Bruce, San Jose, CA 95120 (US)
(74) Representative: Burt, Roger James, Dr.

(57) **Abstract**

A process (and the resulting products) are disclosed which enable oxide superconductors such as REBa₂CU₃O₆₊ₓ to be melt processed on various substrates, including a silver substrate or within a silver sheath. The process comprises melting a precursor material in an oxygen pressure that is chosen to ensure that the melting point of the precursor is less than that of the substrate and then solidifying the melted precursor material. The solidified material is then fully oxygenated by contacting it with an atmosphere containing oxygen. The process is particularly suitable for making long lengths of superconducting wire.

## Description

The present invention is concerned with a process for making superconductors with high critical current densities and with the products of this process. It is particularly suitable for making long lengths of superconducting wires.

Since 1987, there has been a tremendous effort to develop YBa₂Cu₃O₆₊ₓ (known as the "1-2-3" superconductor) and other superconducting oxides with superconducting transition temperatures (T_{c}) above the boiling point of liquid nitrogen into practical engineering materials. However, several basic materials problems have frustrated this effort.

Superconducting oxides are brittle ceramics, which makes it difficult to form them into the flexible wires or tapes needed for many applications. Early on, researchers tried to circumvent this problem by using so-called "powder-in-tube" processing. In this process, the superconducting oxide is made into a powder and placed inside a metal tube. The tube is then drawn or rolled into a long wire and sintered at high temperature to form a continuous length of superconducting oxide within the metal sheath. A silver tube is typically used for power-in-tube processing of YBa₂Cu₃O₆₊ₓ because silver is one of the few metals that does not react chemically with YBa₂Cu₃O₆₊ₓ during high temperature processing. Moreover, oxygen diffuses fairly easily through silver. This is important because YBa₂Cu₃O₆₊ₓ becomes a 90 K superconductor only when it is fully oxygenated (i.e., YBa₂Cu₃O₆₊ₓ, with x between about 0.8 and 1.0), which can be achieved by slowly cooling the material in oxygen following the last high temperature processing step.

Prior powder-in-tube processing studies of YBa₂Cu₃O₆₊ₓ are described in McCallum et al., Adv. Ceram. Mater., Vol. 2, 1987, page 388; Okada et al., Jpn. J. Appl. Phys., Vol. 27, 1988, page L185; Okada et al., Jpn J. Appl. Phys., Vol. 27, 1988, page L1715; Ishii et al., Jpn. J. Appl. Phys., Vol. 28, 1989, page L1793; and Woolf et al., Appl. Phys. Lett., Vol 58, 1991, page 534.

Powder-in-tube processing did indeed produce flexible wires containing YBa₂Cu₃O₆₊ₓ but the critical current density of these wires (i.e., the maximum current density that the material can carry and remain superconducting) was far too low to be useful (-10³ A/cm² at 77 K with no applied magnetic field). In addition, the critical current density dropped sharply when magnetic fields were applied. The low critical current density in sintered YBa₂Cu₃O₆₊ₓ is caused by a second materials problem; namely, "weak links" at high-angle grain boundaries between YBa₂Cu₃O₆₊ₓ crystals.

Researchers tried to overcome the weak link problem by developing melt processing techniques. These techniques typically heat YBa₂Cu₃O₆₊ₓ above its melting point, resolidify it in a temperature gradient, and then fully oxygenate it at a lower temperature. Unidirectional solidification results in a fully dense, highly textured microstructure with large plate-shaped YBa₂Cu₃O₆₊ₓ grains separated by low-angle grain boundaries. This microstructure differs markedly from the randomly oriented, fine-grained microstructure produced by solid-phase sintering. Critical current densities in melt processed samples are typically in the 10₄ - 10₅ A/cm₂ range with no applied field. Moreover, the critical current densities remain relatively high in large magnetic fields; in the 10₃ - 10₄ A/cm₂ range in fields above 1 Tesla.

To date, however, melt processing techniques have been unable to make long lengths of YBa₂Cu₃O₆₊ₓ wire with high critical current densities. A key reason for this failure is the lack of an inert substrate to contain the very reactive liquid that forms during YBa₂Cu₃O₆₊ₓ melt processing. In contrast to YBa₂Cu₃O₆₊ₓ, there has been much more success in making melt processed, silver-sheathed wires containing Bi₂Ca₁Sr₂Cu₂O₈₊ₓ and Bi₂Ca₂Sr₂Cu₃O₁₀₊ₓ. As noted on page four of the February 4, 1991, edition of Superconductor Week, "Bismuth-system superconductors are coming much further along because they can be melt-grown below the melting temperature of silver, but 1-2-3 exhibits better performance" (at 77 K).

Prior melt processing studies of YBa₂Cu₃O₆₊ₓ are described in Jin et al., Phys. Rev. B., Vol. 37, 1988, page 7850; Jin et al., Appl. Phys. Lett., Vol. 52, 1988, page 2074; Salama et al., Appl. Phys. Lett., Vol. 54, 1989, page 2352; Murakami et al., Jpn. J. Appl. Phys., Vol. 28, 1989, page 1189; McGinn et al., Physica C, Vol. 165, 1990, page 480; and Meng et al., Nature, Vol. 345, 1990, page 326.

A key variable that is ignored in prior powder-in-tube and melt processing studies of YBa₂Cu₃O₆₊ₓ is the oxygen partial pressure during high temperature processing. The prior art uses air or one atmosphere oxygen during processing. The melting point of YBa₂Cu₃O₆₊ₓ in one atmosphere oxygen is 1035°C, while the melting point of silver is 931°C. Consequently, the powder-in-tube studies were carried out below 931°C to prevent the silver sheath from melting. Below 931°C in air or one atmosphere oxygen, the YBa₂Cu₃O₆₊ₓ powder in the tube does not undergo melt processing (it just sinters), so the microstructure produced by melt processing (which supports high critical current densities) does not form. Conversely, silver has not been considered as a substrate for melt processing of YBa₂Cu₃O₆₊ₓ because the melting point of silver is less than the melting point of YBa₂Cu₃O₆₊ₓ in air or one atmosphere oxygen. Thus, the prior art has not been able to produce long lengths of high critical current density wires of superconductors such as 1-2-3.

Accordingly, it is an object of this invention to provide an improved technique for making high critical current density oxide superconductors on electrically conductive substrates.

It is another object of this invention to provide an improved technique for making superconducting wires having high critical current density on electrically conductive substrates, where the superconductors can be formed at temperatures less than the melting point of the substrate.

It is another object of this invention to provide an improved technique for forming REBa₂Cu₃O₆₊ₓ ("1-2-3") superconductors on substrates containing silver.

It is another object of this invention to provide an improved technique for forming 1-2-3 superconductors on substrates containing silver using precursors having melting points which can be adjusted to be less than the melting point of the substrate.

It is another object of this invention to provide an improved technique for forming oxide superconductors on electrically conducting substrates using precursor materials, where the technique utilizes process conditions ensuring that the melting point of the superconductor precursor material is less than that of the substrate.

It is another object of the present invention to provide an improved technique for making 1-2-3 superconductors on substrates containing silver, where the processing conditions are relaxed in order to ensure high critical current density of the superconductors.

It is another object of the present invention to provide an improved process, and the superconductor products formed thereby, where high critical current density 1-2-3 superconductors can be formed on electrically conductive substrates at processing temperatures which are less than the melting point of the substrate material.

It is another object of this invention to provide a process for forming high T_{c} oxide superconductors on electrically conductive substrates, and the products produced thereby, where the superconductors have a crystalline microstructure sufficient to enhance the critical current density of the superconductors, the processing conditions being chosen to make the melting point of the precursor material used to form the superconductor less than the melting point of the substrate.

According to the present invention there is provided a process for making a superconductor with a high critical current density, said process comprising the steps of: (1) contacting an electrically conductive substrate and a solid material which is a precursor of a superconducting oxide having the formula REBa₂CuO₆₊ₓ wherein RE is Y,Dy,Ho,Er,Tm,Yb or Lu and x is between about 0.8 and 1.0; (2) heating said substrate and precursor material in an oxygen-containing ambient to a temperature below the melting point of said substrate, but above the melting point of REBa₂Cu₃O₆₊ₓ, while maintaining the pressure of said oxygen sufficiently low to ensure that the melting point of REBa₂Cu₃O₆₊ₓ is below the melting point of said substrate, to thereby melt said precursor material; (3) solidifying the melted material; and (4) fully oxygenating the solidified material by exposing it to an atmosphere containing oxygen for a time and pressure sufficient to make it an above 77 K superconductor having the formula REBa₂Cu₃O₆₊ₓ.

According to a specific embodiment of the present invention there is provided a process for making a superconductor wire with a high critical current density, said process comprising the steps of: (1) encasing in an electrically conductive sheath a solid material which is a precursor of a superconducting oxide having the formula REBa₂Cu₃O₆₊ₓ, where RE is Y,Dy,Ho,Er,Tm,Yb or Lu and x is between about 0.8 and 1.0; (2) feeding said precursor material and said sheath through a heating zone in an oxygen-containing ambient to a temperature below the melting point of said sheath, but above the melting point of REBa₂Cu₃O₆₊ₓ, while maintaining the pressure of oxygen sufficiently low to ensure that the melting point of REBa₂Cu₃O₆₊ₓ is below the melting point of said sheath, to thereby melt said precursor material; (3) solidifying the melted material; and (4) fully oxygenating the solidified material by exposing it to an atmosphere containing oxygen for a time and pressure sufficient to make it an above 77 K superconductor having the formula REBa₂Cu₃O₆₊ₓ.

According to a further embodiment of the present invention there is provided a process for making an oxide superconductor having a Tc > 77 K and high critical current density, said process including the steps of: contacting an electrically conductive substrate and a material which is a precursor of a superconducting oxide, said precursor having a melting point which is a function of oxygen pressure; heating said precursor and said metallic substrate in an oxygen-containing ambient chosen to have an oxygen pressure such that the melting point of said precursor is less than the melting point of said substrate, said heating being to a temperature sufficient to melt said precursor but not said metallic substrate; solidifying said melted precursor material; and adjusting the oxygen content of said solidified material to achieve the desired stoicheiometry for said oxide superconductor.

According to another embodiment of the present invention there is provided a superconducting oxide conductor product having a Tc > 77°K formed by the following process: contacting an electrically conductive substrate and a material which is a precursor of a superconducting oxide, said precursor having a melting point which is a function of oxygen pressure; heating said precursor and said substrate in an oxygen-containing ambient chosen to have an oxygen pressure such that the melting point of said precursor is less than the melting point of said substrate, said heating being to a temperature sufficient to melt said precursor but not said metallic substrate; solidifying said melted precursor material; and adjusting the oxygen content of said solidified material to achieve the desired stoicheiometry for said oxide superconductor.

According to a particular embodiment of the present invention there is provided a superconductor product, wherein said superconductor product has a nominal composition AB₂C₃Oₓ, where A is a rare earth element or an element selected from the group consisting of Y, La, Sc, B is an alkaline earth element, C is a transition metal, O is oxygen, and x has a value which ensures that said superconductor product is superconducting above 77 K.

In a particular embodiment of the present invention there may be found an improved technique, and the products produced thereby, wherein oxide superconductors can be formed on electrically conductive substrates in a manner to ensure that enhanced critical current densities are obtained. In particular, it is often desirable to melt the precursor material used to form the superconductor in order to obtain a microstructure in the superconductor which will produce enhanced critical current density. However, if the precursor material melts at a higher temperature than the substrate, some of the desired superconductor properties can be adversely affected. The present invention uses low oxygen pressure during a heating step to ensure that the precursor melting point is less than the substrate melting point. This in turn enables the use of many different precursor-substrate combinations in order to form superconductive wires, etc. that can carry high currents.

In a particular example, the melting points of YBa₂Cu₃O₆₊ₓ and silver depend on the oxygen partial pressure; the melting point of YBa₂Cu₃O₆₊ₓ decreases and the melting point of silver increases as the oxygen pressure decreases. In fact, the melting point of YBa₂Cu₃O₆₊ₓ can be made lower than the melting point of silver by using low oxygen pressures. Thus, YBa₂Cu₃O₆₊ₓ can be melt processed in low oxygen pressure on silver; an inert, ductile, electrically conductive substrate or sheath.

These and other objects, features, and advantages will be apparent from the following more particular description of the preferred embodiments.

As noted, the technique of this invention is particularly suited for making 1-2-3 high Tc superconductors with a high critical current density, as exemplified by the following process comprising the steps of: (1) contacting an electrically conductive substrate and a solid material that is a precursor of a superconducting oxide having the formula REBa₂Cu₃O₆₊ₓ wherein RE is Y,Dy,Ho,Er,Tm,Yb or Lu; (2) heating said substrate and precursor material to a temperature below the melting point of said substrate, but above the melting point of REBa₂Cu₃O₆₊ₓ, while maintaining the pressure of oxygen sufficiently low to ensure that the melting point of the REBa₂Cu₃O₆₊ₓ is below the melting point of said substrate; (3) solidifying the melted material by lowering the temperature or by adding oxygen at a pressure sufficient to solidify it; and (4) fully oxygenating the material by exposing it to an atmosphere containing oxygen for a time and pressure sufficient to make it a superconductor having the formula REBa₂Cu₃O₆₊ₓ. In the above formula REBa₂Cu₃O₆₊ₓ, the letter x is used to mean a number which is ideally one. A preferred embodiment of the electrically conductive substrate is silver.

The present invention overcomes the problems of prior melt processing and powder-in-tube methods carried out with REBa₂Cu₃O₆₊ₓ superconductors by melt processing REBa₂Cu₃O₆₊ₓ on a silver substrate in low oxygen pressure. The use of low oxygen pressure is a key feature which distinguishes the present invention from the prior art.

The melting points of REBa₂Cu₃O₆₊ₓ oxides decrease as the oxygen pressure decreases. (See Idemoto et al., Jpn. J. Appl. Phys., Vol. 29, 1990, page 2729.) For example, the melting point of YBa₂Cu₃O₆₊ₓ in one atmosphere of oxygen is 1035°C. We have found that the YBa₂Cu₃O₆₊ₓ in contact with silver can be melted at a temperature below 931°C when low oxygen pressures (below 3x10⁻³atm) are used. The melting point of silver is 962°C in vacuum and 931°C in 1 atm oxygen.

YBa₂Cu₃O₆₊ₓ can be melt processed on a silver substrate or within silver sheaths below the melting point of silver provided that low oxygen pressures (below 3x10⁻³atm oxygen) are employed. The available data (although limited) on the melting temperatures of other REBa₂Cu₃O₆₊ₓ oxides, especially as a function of oxygen pressure, suggests that this method can also be applied to REBa₂Cu₃O₆₊ₓ, where RE is either Dy,Ho,Er,Tm,Yb or Lu. Other substitutions into the basic YBa₂Cu₃O₆₊ₓ structure that depress the melting point may also be amenable to reduced-oxygen-pressure melt processing in solid silver sheaths or on silver substrates.

For the REBa₂Cu₃O₆₊ₓ materials, the starting point is a material which is a precursor of a superconductor having the formula REBa₂Cu₃O₆₊ₓ, i.e., it is a material in which the metals are in the ratio RE₁Ba₂Cu₃. Most conveniently, the metals are present as reduced oxides, like BaCu₂O₂. Thorough mixing is still advisable even though the subsequent melting facilitates homogeneity. The exact oxygen content of the starting material is not critical. In fact, there is some advantage to having the oxygen content low because it facilitates melting of the precursor. The most important points are that the precursor material has the correct 1-2-3 ratio of RE, Ba, and Cu and that the precursor material, under low oxygen pressure, melts at a temperature below that of the substrate.

It can be advantageous to add small amounts of powdered silver to the precursor material. By small amounts we mean of the order of 10 to 20 weight %. This addition tends to improve the mechanical properties of the superconductor.

The precursor material can simply be placed on a silver substrate and then subjected to the process. The substrate can have raised edges to guard against having the melted material flow off. The silver substrate can be flat, or can be patterned to encourage graphoepitaxy. When it is desired to make long lengths of wires, the silver can be used as a sheath to encase the precursor material completely. The process of the present invention is also applicable to the making of single crystals of superconductor using a silver crucible or a silver-lined crucible as the container.

It is convenient, particularly when it is desired to make wires, that the heating take place in a zone supplied with one or more heating elements. The silver-sheathed precursor material is passed through the heating zone in reduced oxygen pressure and melted. The material is solidified either by increasing the oxygen pressure at a constant temperature or by lowering the temperature while maintaining a reduced oxygen pressure. As mentioned previously, silver has the advantage of being permeable to oxygen at the temperatures involved so that oxygenation can take place through the silver sheath, or substrate. Silver also has the advantage of being nonreactive with the superconductor and its precursor. For permeability to oxygen to be sufficiently fast, the silver sheath should preferably be 0.1 mm or less in thickness. The thickness of the precursor material is also of the order of about 0.1 mm.

In still another preferred variation of the present invention, the oxygen can be supplied by an oxygen-ion conducting solid electrolyte such as doped zirconium dioxide. The electrolyte may or may not be in contact with the silver. In either case, oxygen can be removed or added to the melt by passing a current of oxygen ions through the solid electrolyte.

When the material has solidified, it can be fully oxygenated by exposure to at least one atmosphere of oxygen for a time sufficient to make it a superconductor having the formula REBa₂Cu₃O₆₊ₓ. This may be done, for example, by exposure to oxygen at one atmosphere pressure and at a temperature of from about 400°C to about 500°C for at least four hours.

This oxygenation can be done with the silver sheath still present or with it removed. The silver sheath can be removed, for example, by melting the silver in 1 atmosphere of oxygen at 931°C, which is below the melting point of YBa₂Cu₃O₆₊ₓ in 1 atmosphere of oxygen, in which case the superconducting material would have to be oxygenated after the removal of the silver.

There is some advantage in having a long continuous wire or tape whose cross-section is essentially in the form of an elongated rectangle, rather than a circle, because the use of a rectangular cross-section minimizes the number of high-angle grain boundaries in the material, thereby enhancing the critical current density of the material.

While the invention has been illustrated with respect to particular embodiments, it will be apparent to one skilled in the art that the teaching of this invention can be applied to any type of oxide superconductor formed on a substrate where the order of melting of the substrate and the superconductor precursor material can be reversed by changing the oxygen pressure. The precursor material can be deposited on the substrate by many different methods. The composition of the precursor could be slightly off the actual cation stoicheiometry of the superconducting phase (e.g. 1-2-3) to promote the formation of second phase pinning centers. An inert, electrically conductive substrate like silver could in fact be present as a buffer layer on another substrate.

## Claims

1. A process for making a superconductor with a high critical current density, said process comprising the steps of:
(1) contacting an electrically conductive substrate and a solid material which is a precursor of a superconducting oxide having the formula REBa₂Cu₃O₆₊ₓ wherein RE is Y,Dy,Ho,Er,Tm,Yb or Lu and x is between about 0.8 and 1.0;
(2) heating said substrate and precursor material in an oxygen-containing ambient to a temperature below the melting point of said substrate, but above the melting point of REBa₂Cu₃O₆₊ₓ, while maintaining the pressure of said oxygen sufficiently low to ensure that the melting point of REBa₂Cu₃O₆₊ₓ is below the melting point of said substrate, to thereby melt said precursor material;
(3) solidifying the melted material; and
(4) fully oxygenating the solidified material by exposing it to an atmosphere containing oxygen for a time and pressure sufficient to make it an above 77 K superconductor having the formula REBa₂Cu₃O₆₊ₓ.

2. A process as claimed in claim 1, wherein the electrically conductive substrate contains silver.

3. A process as claimed in any preceding claim, wherein powdered silver is added to said precursor in an amount up to 30 weight % of the precursor material.

4. A process as claimed in any preceding claim, wherein the heating is carried out by feeding the precursor material and said substrate through a heated zone.

5. A process as claimed in any preceding claim, wherein the melted material is solidified by either lowering the temperature or adding oxygen at a pressure sufficient to solidify it or both.

6. A process as claimed in any preceding claim, wherein the oxygen is supplied by an oxygen-ion conducting solid electrolyte.

7. A process as claimed in any preceding claim, wherein the electrically conductive substrate encases the precursor material.

8. A process for making a superconductor wire with a high critical current density, said process comprising the steps of:
(1) encasing in an electrically conductive sheath a solid material which is a precursor of a superconducting oxide having the formula REBa₂Cu₃O₆₊ₓ, where RE is Y,Dy,Ho,Er,Tm,Yb or Lu and x is between about 0.8 and 1.0;
(2) feeding said precursor material and said sheath through a heating zone in an oxygen-containing ambient to a temperature below the melting point of said sheath, but above the melting point of REBa₂Cu₃O₆₊ₓ, while maintaining the pressure of oxygen sufficiently low to ensure that the melting point of REBa₂Cu₃O₆₊ₓ is below the melting point of said sheath, to thereby melt said precursor material;
(3) solidifying the melted material; and
(4) fully oxygenating the solidified material by exposing it to an atmosphere containing oxygen for a time and pressure sufficient to make it an above 77 K superconductor having the formula REBa₂Cu₃O₆₊ₓ.

9. A process as claimed in claim 8, wherein the electrically conductive sheath contains silver.

10. A process as claimed in claims 8 or 9, wherein the melted material is solidified by lowering the temperature or by adding oxygen at a pressure sufficient to solidify it or both.

11. A process as claimed in any of claims 8 to 10, wherein the oxygen is supplied by an oxygen-ion conducting solid electrolyte.

12. A process as claimed in any of claims 8 to 11, wherein powdered silver is added to said precursor in an amount up to 30 weight % of the precursor material.

13. A superconductor made by a process of any preceding claim.

14. A wire made by a process as claimed in any of claims 8 to 12.

15. A process for making an oxide superconductor having a Tc > 77 K and high critical current density, said process including the steps of:
contacting an electrically conductive substrate and a material which is a precursor of a superconducting oxide, said precursor having a melting point which is a function of oxygen pressure;
heating said precursor and said metallic substrate in an oxygen-containing ambient chosen to have an oxygen pressure such that the melting point of said precursor is less than the melting point of said substrate, said heating being to a temperature sufficient to melt said precursor but not said metallic substrate;
solidifying said melted precursor material; and
adjusting the oxygen content of said solidified material to achieve the desired stoicheiometry for said oxide superconductor.

16. A process as claimed in claim 15, wherein said oxide superconductor includes three cations in the ratio 1-2-3.

17. A process as claimed in claims 15 or 16, wherein said oxide superconductor is YBa₂Cu₃O₆₊ₓ.

18. A process as claimed in any of claims 15 to 17, wherein said substrate contains silver.

19. A process as claimed in any of claims 15 to 18, wherein said precursor contains silver in an amount up to about 30 weight % of said precursor.

20. A process as claimed in any of claims 15 to 19, wherein said metallic substrate encases said precursor.

21. A superconducting oxide conductor product having a Tc > 77 K formed by the following process:
contacting an electrically conductive substrate and a material which is a precursor of a superconducting oxide, said precursor having a melting point which is a function of oxygen pressure;
heating said precursor and said substrate in an oxygen-containing ambient chosen to have an oxygen pressure such that the melting point of said precursor is less than the melting point of said substrate, said heating being to a temperature sufficient to melt said precursor but not said metallic substrate;
solidifying said melted precursor material; and
adjusting the oxygen content of said solidified material to achieve the desired stoicheiometry for said oxide superconductor.

22. A product of a process as claimed in claim 21, wherein said substrate includes silver.

23. A product of a process as claimed in any of claims 21 or 22, wherein said superconductor product has a nominal composition AB₂C₃Oₓ, where A is a rare earth element or an element selected from the group consisting of Y, La, Sc, B is an alkaline earth element, C is a transition metal, O is oxygen, and x has a value which ensures that said superconductor product is superconducting above 77 K.

24. A product of a process as claimed in any of claims 21 to 23, wherein said superconductor product is YBa₂Cu₃O₆₊ₓ.
